# EUROPEAN PATENT APPLICATION

(11) **EP 3 988 178 A1**
(43) Date of publication of application: **27.04.2022**
(21) Application number: 20203715.6
(22) Date of filing: 23.10.2020
(51) Int. Cl.: A62C 3/08, A62C 99/00, G06F 30/00, A62C 35/58

(54) **METHOD AND SYSTEM FOR EVALUATING DESIGNS FOR A FIRE SUPPRESSANT SYSTEM**

(71) Applicant: United Technologies Research Centre Ireland, Limited, T23 XN53 Cork City (IE)
(72) Inventor: RIDOUANE, El Hassan, Cork, T23 A5W0 (IE); CAO, Changmin, Cork, T12 CX82 (IE); WAHBI, Mohamed, Cork, T45 XE00 (IE)
(74) Representative: Dehns

(57) **Abstract**

A method and system for evaluating designs for a fire suppressant system for a space, the method comprising: receiving system requirements defining constraints of the system; obtaining a model of a design designed to satisfy the system requirements; calculating key performance indicators for the model; and evaluating the design by comparing the key performance indicators with the system requirements.

## Description

### TECHNICAL FIELD

The present disclosure is concerned with methods and systems for allowing evaluation of selected designs for a fire suppressant system to enable selection of an optimal design.

### BACKGROUND

Fire suppressant systems are used to deliver a fire suppressant or extinguishing agent in a confined space. Such systems include an arrangement of one or more sources e.g. cylinders, containing fire suppressing agent, pipes, pipe connectors and nozzles to appropriately distribute the fire suppressing agent throughout the space to extinguish or suppress a fire in the space.

Many fire suppressant agents are known. The appropriate agent will depend on the nature of the space and the expected type of fire to be extinguished. Examples include halon-based agents, foams, inert gas, trifluoromethyl iodide (CF3I), hydrofluorocarbons (HFCs), fluoroketones (FKs), water mist. Due to on-going concerns of stratospheric ozone depletion, the use of halon-based agents has largely been phased out under the Montreal Protocol. One exception to this phase-out is on board aircraft. Nevertheless, it is desired, and soon will be required, to use non-halon agents for all new aircraft, and in the future to retrofit halon-based agent with non-ozone depleting alternatives.

The desired layout of the pipes and nozzles, the agent(s) used, quantities of agent and flow rate will all be dependent on characteristics of the space or environment where the system is installed. When designing such systems, designers need to take various factors into account to ensure an optimal system design for the space and environment concerned. Fire suppressant systems typically also have to satisfy safety and regulatory standards and requirements. For example, the placement of the nozzles and the flow rate of the agent should ensure adequate coverage of the space and should not give rise to any overpressure concerns. Other factors, such as the overall size and weight of the system may also be important in some environments such as for fire suppressant systems in aircraft or other vehicles.

Conventionally, design of fire suppressant systems has involved manually drawing out the layout of the pipes, cylinders and nozzles based on expert knowledge and performing iterations and testing until a preferred design is identified. The designer needs to consider the resulting dispersion of the agent in the given space based on e.g. nozzle design and nozzle placement. Because of the large number of possible components, agents and other variations that can be considered for any fire suppression system, this is a time intensive process and depends on the expertise of the designer. Even where computer modelling is used, the large number of parameter variations makes modelling and optimal design impractical in terms of computational requirements and such processes are, again, very time intensive.

There is, therefore, a need for a method and system for allowing such fire suppressant systems to be designed in an efficient and optimal manner.

### SUMMARY

Provided herein is a method of evaluating selected designs for a fire suppressant system for a space for optimizing design thereof, the method comprising: receiving system requirements defining constraints of the system; obtaining a model of a design designed to satisfy the system requirements; calculating key performance indicators for the model; and evaluating the design by comparing the key performance indicators with the system requirements.

According to another aspect, there is provided a system for optimizing design of a fire suppressant system for a space, the system comprising: means for receiving system requirements defining constraints of the system; means for obtaining a model of a design designed to satisfy the system requirements; means for calculating key performance indicators for the model; and means for evaluating the design by comparing the key performance indicators with the system requirements.

In one example, a database of system requirements can be created based on user input and receiving the system requirements from the database.

Obtaining the model may include generating a physics-based one-dimensional model of the design by means of a one-dimensional hydraulic calculator process.

Obtaining the model may comprise generating a three-dimensional model of the design from which the physics-based one dimensional model is generated.

One or more output designs may be output based on the evaluation.

In one example, several models of several designs that satisfy the system requirements are obtained and evaluated and wherein selected designs are provided as an output based on the evaluation.

Obtaining the model may include using a constraint programming model using discrete integer variables, graph variables and global reasoning constraints.

The database, if used, may be updated based on feedback from the evaluation step.

The system requirements may include e.g. size, weight, volume, pressure, temperature and/or cost requirements.

The key performance indicators may include e.g. cost, weight, occupied space and/or performance.

One space where the method and system can be applied is the interior of an aircraft.

### BRIEF DESCRIPTION OF THE DRAWINGS

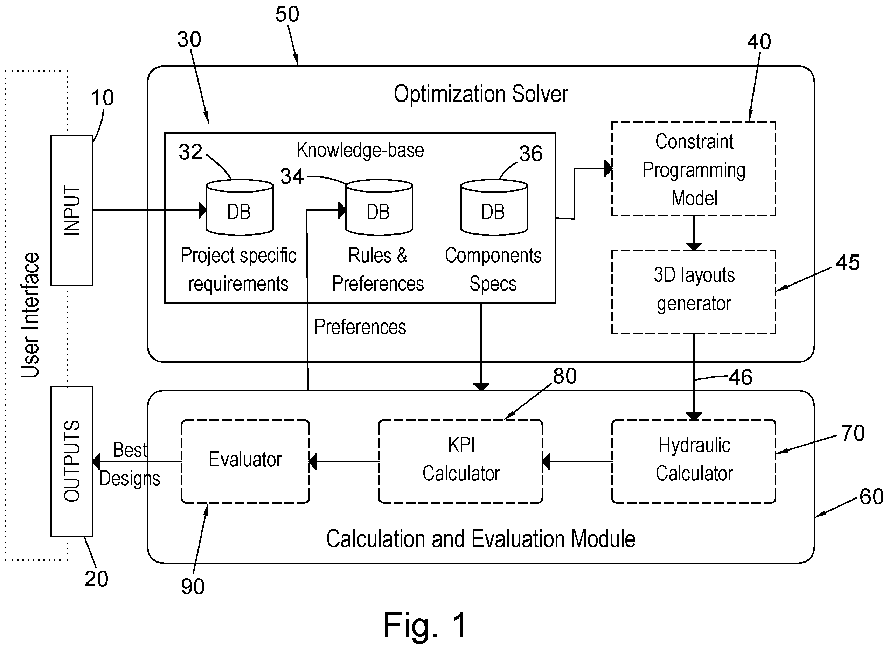

Figure 1 shows a tool chain for designing an optimal fire suppressant system in accordance with this disclosure.

### DETAILED DESCRIPTION

Embodiments will now be described by way of example only and with reference to the drawings.

The disclosure concerns the evaluation of a number of selected possible designs for the layout of a fire suppressant system so that an optimal design can be selected. The evaluation can be performed on possible designs or layouts that may have been obtained in any manner. For the purposes of explanation, the evaluation procedure will be described, purely by way of example, in the context of a tool chain using a constraint programming model such as described in co-filed European Patent Application entitled METHOD AND SYSTEM FOR OPTIMISING DESIGNS OF A FIRE SUPPRESSANT SYSTEM' (Docket 129206EP01) and co-filed European Patent Application entitled 'CONSTRAINT PROGRAMMING METHODS FOR OPTIMAL DESIGN CONFIGURATIONS OF DISTRIBUTION SYSTEMS' (Docket 128498EP01).

Referring first to Fig. 1, a tool chain for an optimal design process comprises a number of modules that perform various functions all based on inputs 10, provided via a user interface 1 defining the system requirements to generate one or more preferred designs 20. The selected optimal design(s) may be output for the designer via the user interface 1.

In the example shown, and as will be described further below, the modules include, an optimization solver 50 and a calculation and evaluation module 60. The optimization solver 50, as described further below, is used to generate a number of possible layouts considered to satisfy the design requirements provided at the input. The optimization solver can generate such layouts in a computationally simple and quick process. The calculation and evaluation module 60 will then evaluate these possible layouts for different scenarios to identify the best design(s), using Key Performance Indicators (KPIs). An optimal design is selected based on the evaluation, for the fire suppressant system.

As mentioned above, the calculation and evaluation module performing the evaluation according to this disclosure can equally operate on selected possible layouts generated in ways other than by the optimization solver described here.

The operation of these modules is described further with further reference to Fig. 1.

First, in order to generate an optimal design, the requirements of the system must been known. These will include various factors such as, by way of example only, requirements necessary to comply with safety and other regulations, size and weight constraints, parameters of the space in which the system is installed e.g. layout, dimensions, temperature, pressure, materials and or fixtures, fittings and furniture in the space, required agent or oxygen concentration , permitted temperature and/or pressure limits, fire suppressant agents to be used, cost constraints and other customer requirements. The system requirements can be input in various ways e.g. they can be manually entered by a user through a variety of interfaces 1 such as a GUI, a keyboard, a mouse etc. Alternatively, they can be automatically received from another system or computer e.g. via a wired or wireless communication interface. These are examples only and the system requirements can be input in any manner.

A knowledge-base 30 is created to contain all of the information required to enable an automated process, including customer requirements (project specific requirements) 32, performance targets, rules and preferences 34, and, where appropriate, component specifications 36. Rules and preferences can be input directly and/or added to the knowledge-base or updated in the knowledge-base based on feedback from the evaluation process described further below.

Using the knowledge-base, the optimization solver 50 selects e.g. sources of suppressant agent and the nozzles, and then generates possible design layouts that meet the system requirements and that provide the required coverage and flow rate. The optimization solver may generate one or more potential layouts. The generation of layouts in this step may be performed using a constraint programming (CP) model 40 using discrete integer variables, graph variables and global reasoning constraints. Such a CP model is described in a co-filed EP application entitled 'CONSTRAINT PROGRAMMING METHODS FOR OPTIMAL DESIGN CONFIGURATIONS OF DISTRIBUTION SYSTEMS' (Docket 128498EP01). The CP model represents combinatorial design-space of possible layouts in terms of discrete integer variables or mathematical objects defining the layouts, in terms of graph variables i.e. mathematical structures composed of nodes and vertices defining the layout and edges/arcs connecting the nodes and vertices, and in terms of global constraints.

The integer variables represent e.g. number of nozzles, cylinders, pipes, connector/test, x-, y- and z-coordinates of the components etc. The graph variables are used to represent the 3D layout of the fire suppression system by representing the devices and the pipes linking them in the design space. The global constraints are set by some of the user requirements. These ensure that the solutions generated by the optimization solver will satisfy the requirements. An example of such a constraint might be that the positions of all of the devices in the design space are different. These constraints are necessary to efficiently filter unfeasible search space so that only feasible components and layouts are considered. It is, however, envisaged that other programs could be used to generate potential layouts that meet the calculated requirements or constraints.

The CP models model the problem in a mathematical formalism in the form of discrete integer variables, graph variables and global constraints. More specifically, the optimization solver will algorithmically explore the combination of layouts/design-space to find feasible system layouts that satisfy the system requirements. The generated representations are provided to a 3D layouts generator 45 and the output 46 of the optimization solver 50 is a 3D representation of the possible layouts. The optimization solver is thus one way of quickly, and with minimum computational cost, generating feasible component combinations and layouts satisfying the design requirements, constraints and preferences from the knowledge-base. At this stage, therefore, undesirable or unfeasible designs are filtered out this lowering the cost and complexity of the subsequent evaluation procedure. The evaluation procedure can, however, also be applied to layouts that have been generated in other ways but then the evaluation may take longer and/or be more computationally expensive.

Once promising layouts that meet the constraints of the system/customer requirements have been generated, the performance of these layouts may be evaluated using a calculation and evaluation module 60 according to the disclosure. This uses physics based models and component specifications to calculate different key performance indicators (KPIs) associated with each of the layouts and performs an evaluation to select one or more preferred designs to propose as outputs 20 to the designer.

In an optional first step of the evaluation, a hydraulic calculator 70 may be used to provide a reduced order or simplified physics-based model of the layout to be evaluated, e.g. defining the layout in terms of parameters such as mass flow rate at each nozzle, pressure drop in pipes, pressure regulators and tees etc. The hydraulic calculator captures the fundamental physical behavior of the layout whilst keeping the computational cost of the simulation low. The hydraulic calculator performs a one-dimensional process to test the actual performance of the proposed design in terms of e.g. mass flow rate at each nozzle, pressure drop in pipes, operation of pressure regulators, pipe connectors etc. to identify if the flow and dispersion of the agent(s) does actually work as required and how effectively it meets the system requirements. At this stage, some designs may be excluded if, for example, they do not meet some system requirement constraints. Those layouts that are not excluded may be forwarded to a KPI calculator 80.

In some embodiments, it can be assumed that all design layouts generated by the optimization solver satisfy the system requirements and the step of evaluation using the hydraulic calculator may be omitted. It is, however, preferred to use the hydraulic calculator to evaluate the selected optimized designs.

In the KPI calculator, Key Performance Indicators are used which are the main indicators or constraints that are to be taken into account to evaluate a proposed layout. These may include KPIs such as cost, weight, occupied space and performance. The KPI calculator 70 calculates the selected KPIs for each layout to be evaluated.

Once the KPIs have been calculated for the layouts, they are evaluated based on the calculated KPIs so as to select the preferred design(s). To do this, an evaluator 90 compares the calculated KPIs for the layouts to performance targets or constraints defined in the project specific requirements, rules and preferences and/or component specs initially set for the design. In the tool chain described above, these targets are stored in the knowledge-base and the calculated KPIs are compared with these targets, in the evaluator 90. Based on the evaluation, the best or preferred design(s) is/are selected to be output to the designer e.g. via the user interface 1. The evaluator may, for example score and/or rank the layouts or designs based on the results of the comparison.

Information obtained from the KPI calculation and/or the evaluation can also be fed back to the stored input requirements e.g. the knowledge-base 30 and used to update and adapt preferences. In this way, new rules and preferences can be learned from previous design projects.

The selected optimal design(s) can be provided as an output that enables the fire suppression system to be built and installed in the 3D-space. The output may be in the form of a description or image or e.g. the number and sizes of any cylinder/source of agent, size and location and type of nozzles as well as piping layout and connections between cylinders and nozzles.

The present methods and tool chains allow optimal design of fire suppression systems for confined spaces e.g. aircraft, designed taking into account all requirements and relevant factors of the space, by means of an automatic evaluation methodology. This results in a significant reduction in expert designer effort and time by providing the designer with a methodology and tools to quickly and easily generate and analyze different design configurations. The designer is able to create multiple design scenarios and evaluate and analyze them with computationally efficient simulation models, thereby enabling the selection of the optimal solution. The cost of development testing and certification is significantly reduced. The method and tool chain can be applied to a wide range of fire suppression system designs.

## Claims

1. A method of evaluating designs for a fire suppressant system for a space, the method comprising:
receiving system requirements defining constraints of the system;
obtaining a model of a design designed to satisfy the system requirements;
calculating key performance indicators for the model; and evaluating the design by comparing the key performance indicators with the system requirements.

2. The method of claim 1, comprising creating a database of system requirements based on user input and receiving the system requirements from the database.

3. The method of claim 1 or 2, wherein obtaining the model includes generating a physics-based one-dimensional model of the design by means of a one-dimensional hydraulic calculator process.

4. The method of claim 3, wherein obtaining the model comprises generating a three-dimensional model of the design from which the physics-based one dimensional model is generated.

5. The method of any preceding claim, further comprising providing an output design based on the evaluation.

6. The method of any preceding claim, wherein several models of several designs that satisfy the system requirements are obtained and evaluated and wherein selected designs are provided as an output based on the evaluation.

7. The method of any preceding claim, wherein obtaining the model includes using a constraint programming model using discrete integer variables, graph variables and global reasoning constraints.

8. The method of claim 2 or any claim dependent thereon, whereby the database is updated based on feedback from the evaluation step.

9. The method of any preceding claim, whereby the system requirements include size, weight, volume, pressure, temperature and/or cost requirements.

10. The method of any preceding claim, whereby the key performance indicators include cost, weight, occupied space and/or performance.

11. A system for evaluating designs for a fire suppressant system for a space, the system comprising:
means (10) for receiving system requirements defining constraints of the system;
means (40) for obtaining a model of a design designed to satisfy the system requirements;
means (80) for calculating key performance indicators for the model; and
means (90) for evaluating the design by comparing the key performance indicators with the system requirements.

12. The system of claim 11, further comprising a database storing system requirements.

13. The system of claim 11 or 12, wherein the means for obtaining the model includes a constraint programming model generating module (40) to provide a three-dimensional model of the design.

14. The system of claim 13, further comprising a hydraulic calculator module (70) to derive a one-dimensional simplified physics-based model of the three-dimensional model.

15. The method or system of any preceding claim, wherein the space is the interior of an aircraft.
